(19) Europäisches Patentamt / European Patent Office / Office européen des brevets

(11) **EP 1 965 497 B1**

(12) **EUROPEAN PATENT SPECIFICATION**

(45) Date of publication and mention
of the grant of the patent:
**01.06.2011 Bulletin 2011/22**

(51) Int Cl.:
**H03M 7/40** (2006.01)

(21) Application number: **07425116.6**

(22) Date of filing: **01.03.2007**

(54) **Distributed arithmetic coding method**

Verteiltes arithmetisches Kodierverfahren

Procédé de codage arithmétique distribué

(84) Designated Contracting States:
**AT BE BG CH CY CZ DE DK EE ES FI FR GB GR HU IE IS IT LI LT LU LV MC MT NL PL PT RO SE SI SK TR**

(43) Date of publication of application:
**03.09.2008 Bulletin 2008/36**

(73) Proprietor: **POLITECNICO DI TORINO**
**10129 Torino (IT)**

(72) Inventors:
- **Grangetto, Marco**
  **10064 Pinerolo (TO) (IT)**
- **Magli, Enrico**
  **10131 Torino (IT)**
- **Olmo, Gabriella**
  **10025 Pino Torinese (TO) (IT)**

(74) Representative: **Quinterno, Giuseppe et al**
**Jacobacci & Partners S.p.A.**
**Corso Emilia 8**
**10152 Torino (IT)**

(56) References cited:
**US-A1- 2002 176 494**

- **QIAN ZHAO ET AL: "Lossless and Near-Lossless Source Codingfor Multiple Access Networks" IEEE TRANSACTIONS ON INFORMATION THEORY, IEEE SERVICE CENTER, PISCATAWAY, NJ, US, vol. 49, no. 1, January 2003 (2003-01), XP011074673 ISSN: 0018-9448**
- **THOMAS GUIONNET ET AL: "Soft decoding and synchronization of arithmetic and quasi-arithmetic codes : application to image transmission over noisy channels" JOINT PHOTOGRAPHIC EXPERT GROUP CONFERENCE, CROWBOROUGH : JPEG FORUM LTD, GB, 22 July 2003 (2003-07-22), XP017205077**

# EP 1 965 497 B1

## Description

The present invention relates to a method of distributed source coding.

More specifically the invention relates to a method to perform the coding and the decoding of communication data coming from statistically dependent sources.

Document US 2002/176494 discloses a coding and decoding method of the type of the present invention.

In recent years, distributed source coding has received an increasing attention from the academics that address of analysis and signals processing. The distributed source coding considers the situation in which two or more statistically dependent data sources must be encoded by two separate encoders that are not allowed to talk each other, i.e., when the two sources are not jointly available (i.e., they are not within the same device) and therefore the communication between them would be impossible or very expensive, as in the case of a network of wireless sensors. In this case, each encoder has available only the data coming from one of the two sources. Equally appealing is the possibility of applying distributed source coding principles to situations where a single source is artificially subdivided into correlated sub-sources that are encoded separately, e.g., different frames of a video sequence. In this case the advantage is that decorrelation among the sub-sources is no longer required, thus simplifying the encoder (though at the expenses of the decoder).

The two encoders can perform lossless compression of the two sources each by using a bit rate greater than the entropy of either source; however, this type of separate compression constitutes a loss of efficiency with respect to the use of an encoder that jointly compresses the two sources, since in this case a bit rate equal to the joint entropy of the sources could be used, which is smaller than the entropy of each source.

The distributed source coding theory has proved that, under certain assumptions, the same result as the joint coding can be achieved by using two separate encoders, provided that the two sources are decoded by a joint decoder. It is possible to get this performing a standard encoding of one of the two sources (called "side information") at its entropy value, and an "ambiguous" encoding of the other source at a rate lower than its entropy, with no information about the first source available at the second encoder. A source is encoded ambiguously when data of said source are transmitted in the form a sequence of symbols so that non to guarantee at the decoder a perfect and univocal acknowledgement of the symbol transmitted.

The encoders which perform the distributed source coding are typically implemented using channel codes, i.e. by representing the source using its syndrome (or the parity bits) for a given channel code suitable for a given correlation amount between the two sources. The channel codes are used because they, having the side information, allow to perform the decoding of a source encoded ambiguously with a minimum error probability.

The distributed source coding theory comprises not only lossless compression but also lossy compression; it has been shown that, under certain condition, there is no performance loss in using distributed source coding as opposed to joint coding. In practice, lossy distributed source coding is typically implemented using a standard quantizier followed by lossless distributed source coding (entropy coding), while the decoder consists of a joint entropy decoder followed by a joint dequantizer.

The applications of distributed source coding schemes to realistic signals are typically limited by some problems. In particular, for example, channel codes require very large data blocks (typically in excess of 10.000 symbols). This requirement is not always compatible with practical applications, where the basic units to be encoded are of the order of a few hundreds to a few thousands symbols. Furthermore, channel codes require that the symbols contained in each block follow always a stationary statistical distribution, hypothesis not suitable for data as images and video sequences, for example. Moreover the conditional entropy of a stationary distribution constraints the bit rate.

Channel codes have an high coding complexity, typically in the order of the square of the dimension of the data block, and therefore this complexity rises very quickly when the dimension of the block increases; other side, a big block dimension is a prerequisite for the use of this channel codes, from which the high complexity of the coding process derives.

An object of the present invention is to propose a source encoding and decoding method which can overcome the above stated problems.

This and other objects are achieved according to the invention with a coding and decoding method whose main characteristics are defined in claims 1 and 7.

Further characteristics and advantages of the invention will become clear from the following detailed description, given purely by way of non limiting example, with reference to the attached drawings, in which:

- figure 1 is an illustrative scheme of a binary arithmetic coding method according to the prior art;
- figure 2 is a scheme related to a binary arithmetic distributed coding method according to the invention;
- figure 3 is a scheme of a branch of a distributed arithmetic decoding tree; and
- figure 4 is a scheme of branches of a distributed arithmetic decoding tree having a side information ambiguously coded.

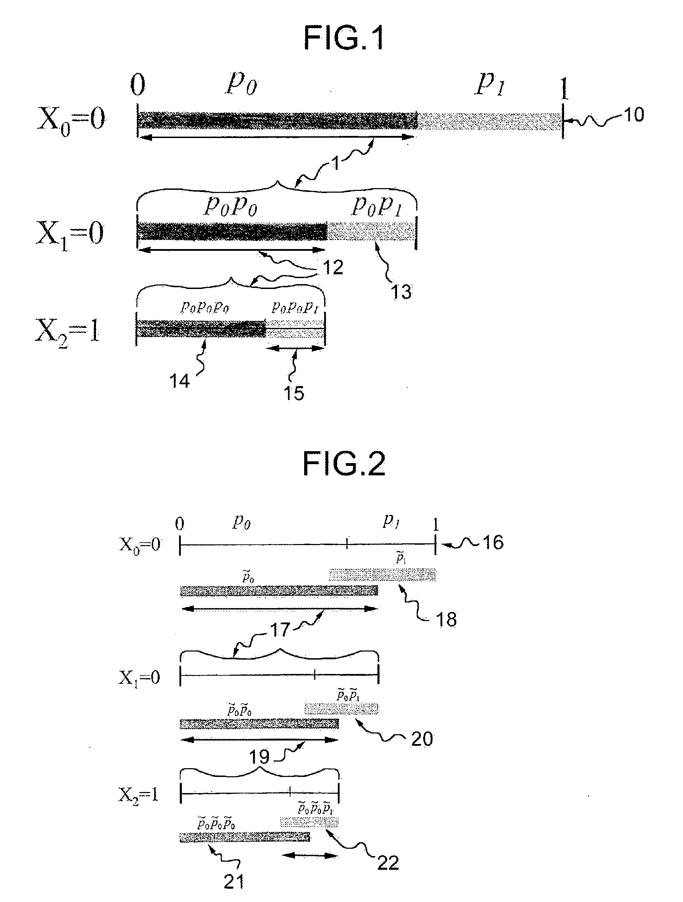

Figure 1 shows a scheme of an arithmetic coding method or AC coding (Arithmetic Coding) according to the prior art. In the arithmetic coding the starting point is a set of symbols $[X_0, X_1, ..., X_i, ..., X_{N-1}]$ which is a length-N symbol sequence where each symbol belongs to an M-ary alphabet. The arithmetic encoding process is based on either the knowledge or the estimation of the probability of each character of the M-ary alphabet at time i, which we denote as $p_{1,i}$, $p_{2,i}, ..., p_{M,i}$. The summary of the probability associated with the various characters of the M-ary alphabet, in each time, is equal to one. For simplicity, we will denote the set of probabilities as $p_1, p_2, ..., p_M$ though it is intended that these probabilities can vary at each encode step, e.g., when an estimation algoritm based on symbol statistics is used.

The arithmetic coding is based on the recursive interval partition according to a given probability, known as Elias coding, which encodes symbols through intervals. The source symbols are associated with sub-intervals of a starting interval so that they constitute a partition of it, i.e. they are not overlapped and their union is equal to the starting interval.

At the beginning, the "current" interval is equal to the starting interval and it is set to [0,1). For each input symbol $X_i$ of the sequence to be coded, the "current" interval is partitioned into a set of M adiacent sub-intervals whose lengths are proportional to $p_1, p_2, ...p_M$. The sub-interval representing the symbol $X_i$ is selected as the next "current" interval.

After all N symbols have been processed, the sequence is represented by the last "current" interval, denoted as final interval.

The representation of the M-ary sequence can consist in any number within said final interval. For example, it is possible to select an endpoint of the final interval, the midpoint of the sub-interval or any other number belonging to the interval. For the transmission or for the writing on a numeric support such number will have to be transformed in a representation of it (typically binary) indicated codeword. In particular, for using the lowest bit rate per symbol the number can be chosen within the interval represented by the shortest codeword.

Knowing or estimating the probabilities of the symbols, the decoder is able to perform the same partitions, and hence, given the number within the final interval, it is able to reconstruct the sequence of partitions or selections that have generated it.

The example of figure 1 shows a method of binary arithmetic coding, namely having M equal to 2, which codes a string of N=3 symbols, where the symbols are $X_0=0$, $X_1=0$ e $X_2=1$. The probability of the character 0 is indicated $p_0$ and the probability of the character 1 is indicated $p_1$. In figure 1 the starting interval [0,1) is indicated 10, which is subdivided into two sub-intervals respectively proportional to probability $p_0$ and probability $p_1$.

Since the first symbol of the sequence to encode is $X_0=0$, the sub-interval corresponding to the symbol $X_0$ is selected within the "current" starting interval, in this case the sub-interval 11 having probability $p_0$. This sub-interval 11 becomes now the new "current" interval and it is subdivided in two sub-intervals 12 and 13 respectively proportional to $p_0$ e $p_1$.

At this point, since the second symbol of the sequence to transmit is $X_1=0$, the sub-interval 12 of the new "current" interval 11 corresponding to the symbol $X_1$ is selected. The sub-interval 12 is then subdivided into two sub-intervals 14 and 15 respectively proportional to $p_0$ and $p_1$.

Since now the third symbol of the sequence to transmit is $X_2=1$, the sub-interval 15 is selected as final interval and any binary number included in said final interval 15 represent correctly the sequence $X_0$ $X_1$ $X_2$.

The arithmetic coding above disclosed provides a reversible description (without loss of information) of the input sequence X.

It will be now disclosed the distributed arithmetic coding according to the invention. It provides, differently from the simple arithmetic coding above described, an ambiguous and more compressed description of the sequence X, which can be decoded losslessly only if the side information Y is available at the receiver; said receiver is a soft joint decoder.

The codewords representing X and Y are indicated $C_x$ and $C_y$ and the respective encoding rates are indicated $R_x$ and $R_y$, expressed in bit rate.

The side information Y can be coded respectively unambiguously ($R_y \geq H(Y)$) or ambiguously ($R_y < H(Y)$), in which H(Y) is the entropy of Y. The decoder can use the side information coded in any of the two modes.

It is therefore possible to perform two different coding, the first having the side information available unambiguously, the second having the side information available ambiguously.

In the coding with side information available unambiguously, the unambiguity is given by the number selected in the final interval; using interval partition at each step of the arithmetic coding process ensures that each real number in the interval [0,1) belongs to only one out of all possible sequence of interval sub-divisions and selections, each of which corresponds to a different input information sequence.

Distributed arithmetic coding is based in this case on the principle of inserting an ambiguity only in the sequence X so as to allow to use a less bit rate than in the case in which a sequence X non ambiguous is available. The sequence X can be decoded correctly if the side information is provided. The ambiguity is inserted using one of the three following modes.

In the first mode (mode 1), the distributed arithmetic coding employs a modified interval sub-division strategy.

A set of intervals whose amplitude is increased and proportional to a modified set of probabilities $\tilde{p}_j$ such that $\tilde{p}_j \geq p_j$ is used, where the subscript j=1, ...,M indicates the different characters of the coding alphabet. As a consequence, the sum of the probabilities of all the characters is greater than 1. In order to fit the enlarged sub-intervals inside the [0,1) interval, said sub-interval must be partially overlapped, as shown in figure 2. This leads to a larger final interval which can be described using a shorter codeword.

In mode 2 (mode 2), the distributed arithmetic coders employs the same interval partition as the standard arithmetic coding, i.e. $\tilde{p}_j = P_j$. In order to insert some ambiguity, a certain number of bits are removed from the output codeword, and said bits removed are not communicated to the decoder. This bit remover process allows the encoder to employ a reduced bit rate for the encoding. Several removal patterns can be used, e.g. a number of equally spaced bits in the output strings can be removed, or a number of randomly selected bits, or a number of bit selected in such a way that the probability of decoding error is minimum, and so on.

In the third mode (mode 3), the distributed arithmetic coding employs a combination of the first and the second mode, that is the intervals are partially overlapped and some bits are removed from the output codeword. The design of the overlapping rule and bit removal rule is done in such a way as to achieve the desired bit rate.

Optionally, a cyclic redundancy code can be appended to the output codeword in order to facilitate the code error detection.

In the encoding with side information available ambiguously a coding with a bit rate close to the joint entropy is achieved by encoding both X and Y with ambiguity rather than leaving all the ambiguity only in X.

The distributed arithmetic coding process can indeed be modified as follows in order to achieve a time sharing distributed arithmetic coding. If mode 1 encoders are used, this is applied to X and Y, with the provision that the i-th symbol $X_i$ is coded with overlapped intervals if and only if the i-th symbol $Y_i$ is not coded with overlapped intervals. This can be achieved e.g. by coding with overlapping the even symbol of X, while coding with classical partition without overlap the odd symbols. Conversely, odd symbols of Y are coded with overlapping interval while even symbols are coded onto separated intervals. Alternatively, the symbols to which the overlapping is applied are chosen according to a predetermined rule (for example a random sequence), in which it is allowed to have a different proportion of symbols with overlapping in each sequence.

The same time sharing strategy can be used in the case of bit removal (mode 2) by guaranteeing that if a bit at a certain position i within the codeword of X is removed, the same position i is not selected for removal in the codeword representing Y. This time sharing approach allows one to design a joint sequential decoder able to reconstruct both correlated sequences.

This algorithm can be extended to the case of multiple side information sources $Y_1$, ..., $Y_M$, where the available encoding rate is distributed in an arbitrary way among the sources. In this case, the distributed arithmetic coding is applied to each sources and, for each source, the symbols where overlap is used, as well as the amount of overlap, are chosen so as to achieve the desired bit rate for the coding and minimize the probability of decoding errors.

In figure 2 an example of a binary distributed arithmetic coding method is shown, having namely M equal to 2, according to a embodiment of the invention. The method encodes a string of N = 3 symbols, in which the symbols are $X_0 = 0$, $X_1 = 0$ e $X_2 = 1$. The probability and the modified probability of character 0 are respectively indicated $p_0$ and $\tilde{p}_0$, and the probability and the modified probability of character 1 are respectively indicated $p_1$ and $\tilde{p}_1$

In such figure the starting interval [0,1) is indicated 16, and at initialization it is considered as "current" interval. Said interval [0,1) is subdivided into two sub-intervals partially overlapped 17 and 18, respectively proportional to probability $\tilde{p}_0$ and probability $\tilde{p}_1$; as a consequence of said overlapping, a certain amount of ambiguity is present in the final binary representation. In particular, at the decoder side, whenever the binary sequence points to the non overlapped region of a certain sub-interval, the corresponding information symbol can be decoded without ambiguity. On the contrary, if the codeword points to the overlapped region, the source symbol can not be decoded unambiguously. In this latter case, the correlated side information must be provided to the decoder.

Since the first symbol of the sequence to encode in this case is $X_0 = 0$, the sub-interval corresponding to symbol $X_0$ is selected within the "current" starting interval, in this case the sub-interval 17 having the probability $\tilde{p}_0$. This sub-interval 17 becomes now the new "current" interval and it is subdivided in two sub-intervals 19 and 20 partially overlapped, respectively proportional to $\tilde{p}_0$ and $\tilde{p}_1$.

At this time, since the second symbol of the sequence to transmit is $X_1 = 0$, the sub-interval 19 of the new "current" interval 17 corresponding to symbol $X_1$ is selected. The sub-interval 19 is then subdivided into two sub-intervals 21 and 22, partially overlapped proportional relatively to $\tilde{p}_0$ and $\tilde{p}_1$.

Since now the third symbol of the sequence to transmit is $X_2 = 1$, the sub-interval 22 is selected as final interval, and any binary number within said final interval 22 represents correctly the sequence $X_0 X_1 X_2$.

The method above disclosed with reference to source X can be obviously applied to source Y. The symbols of said source Y can belong to an M-ary alphabet having M different from that of the alphabet associated with the source X. In this case, for the source Y a starting interval [0,1) will be subdivided into M sub-intervals in which M is that associated with the source Y.

The average rate spent to perform the distributed arithmetic coding, expressed in bit per input symbol, is given by the following equation:

$$R = \sum_{j=1}^{M} p_j \log_2 \frac{1}{\widetilde{p}_j} \quad (1)$$

As an example, each probability can be amplified by a factor $\alpha_j \geq 1$, from which derives that $\widetilde{p}_j = \alpha_j p_j$. As a consequence, the average coding rate R becomes the following:

$$R = \sum_{j=1}^{M} p_j (\log_2 \frac{1}{p_j} - \log_2 \alpha_j) = \sum_{j=1}^{M} p_j (r_j - \delta r_j) \quad (2)$$

where $r_j = -\log_2 p_j$ and $\delta r_j = \log_2 \alpha_j$, and this last represents the number of bits removed from the binary representation of the i-th symbol.

In one embodiment of the present invention, the amplification factors $\alpha_j$ can change at each encoding step, i.e. $\alpha_j = \alpha_{j,i}$, according to a suitable rule that determines the average instantaneous rate to assign to the i-th input symbol.

In an other embodiment of the present invention, one may want to use constant $\alpha_j = \alpha$. In an other embodiment one may want to keep constant the ratio $\delta r_j / r_j = k$, which is equal to setting $\alpha_j = p_j^{-k}$, with $0 \leq k \leq 1$. In this latter case, the expression of the average coding rate R can be further simplified as follows:

$$R = (1-k) \sum_{j=1}^{M} p_j \log_2 \frac{1}{p_j} = (1-k) H \quad (3)$$

where H is the entropy of the probability model, i.e.

$$H = -\sum_{j=1}^{M} p_j \log_2 p_j \quad (4)$$

It is evident that the coding rate can be reduced to any desired value by means of suitable selection of parameter k.

It will be now disclosed the distributed arithmetic decoding method object of the invention.

The aim of the distributed arithmetic decoding is to decode the source message X and the correlated side information Y. In the most general case both X and Y are available to the decoder as entropy coded codeword $C_X$ and $C_Y$. The decoder is arranged to perform a sequential search along a proper decoding tree where each node represents a state of the sequential arithmetic decoder. The decoding tree can be symbol "driven", when each transition is "driven" by the output of a given source symbol, or bit "driven", when each transition represents the decoding of a fix number of coded bit, corresponding to a variable number of source symbols.

The present invention applies for any decoder which uses a proper sequential search algorithm along an arithmetic decoding tree in order to maximize a certain metric, so as to select the most likely pair X and Y. Several metrics are possible; a valid criterion is based on the Maximum A Posteriori (MAP) metric which is indicated with P ($X_0$, $X_1$, ..., $X_{N-1}|C_X$, $C_Y$).

It is worth pointing out that this metric also encompasses the case of Y is coded using a distributed arithmetic coding, and can be extended to the case of more than one side information Y.

The MAP metric can also be replaced with an other criterion, as for example the minimum distance, according to the context or the complexity of the desired decoding.

Several embodiments of the decoding method will be disclosed in the following. In particular, different decoding methods in case of side information coded unambiguously or ambiguously will be disclosed.

At first it is considered the case in which the encoding has been performed with interval overlapping (mode 1).

In this case it is used a symbol "driven" decoding tree.

Then, it is presented the achievement of a decoding in the case in which the encoding has been performed with bit removal (mode 2). In this case a bit "driven" decoding tree is used.

The decoding for data coded in the third mode (mode 3), i.e. combination of mode 1 and 2, can be obtained straightforwardly by extending the presented example of decoding.

It is worth noticing that the proposed decoding method can be used to decode more than two correlated sources, provided that the decoding metric takes into account all the correlations. As an example, if the source X is correlated with source $Y_1$, ..., $Y_M$, its decoding metric turns out to be P $(X|C_X, C_{Y1}, ..., C_{YM})$.

In a first embodiment of the decoding method we assume that the side information is available at the decoder unambiguously; this is the case when the side information is encoded with a standard approach (for example the standard entropy coding). The correlated source X can be encoded with almost H $(X|Y)$ bit per symbol, by means of the proposed distributed arithmetic coding with properly overlapped intervals. In this particular situation the decoder must solve the ambiguity on X, resulting from intervals overlapping, by using the side information Y and the correlation model P $(X|Y)$.

This objective can be achieved with the sequential distributed decoding maximizing the MAP metric P $(X|C_X, C_Y=Y)$.

In the decoding the received codeword $C_X$ is processed, which is a representation, typically binary, of a number lying in the final interval selected by the encoder. The decoder steps are as follows:

1) Initialize the current interval to [0,1).
2) Subdivide the interval according to the probabilities $\tilde{p}_j$.
3) Initialize the coding tree.
4) While the number of the decoded symbols is less than N (and/or the termination condition is met):

- for every node in the tree:

  - compare $C_X$ with the current interval subdivision;
  - if $C_X$ belongs to the non overlapped portion of a certain interval, decode the corresponding symbol $X_i$ without ambiguity and select the corresponding interval for next iteration of this node;
  - if $C_X$ lies in the overlapped region between two or more intervals, perform a decoding branching; store K alternative paths, corresponding to the $K \leq M$ alternative symbols $X_i$ that can be decoded, upgrade their MAP metrics and select the corresponding interval for next iteration;

- optionally adopt pruning techniques in order to limit the number of most likely paths stored in memory; for example it can be used the Viterbi algorithm, stack and "M" algorithm.

5) Output the sequence corresponding to the most likely path in the tree.

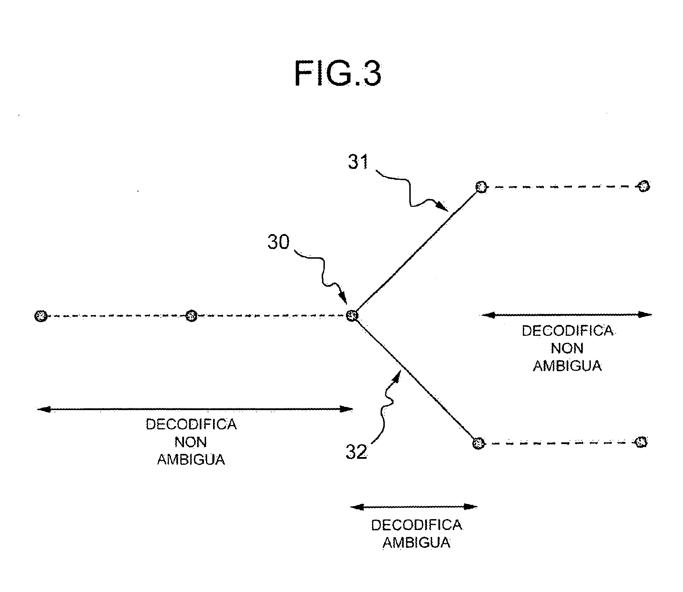

In figure 3 a distributed arithmetic decoding branching tree for the binary case is illustrated. In particular, in the reported example, the decoder in not able to take a decision on the i-th symbol $X_i$, indicated by the node 30. As a consequence, two alternative decoding attempts are pursued, branches 31 and 32. As in this example the input source is binary, on one hand the $X_i$=0 hypothesis is considered, branch 31, and the MAP metric P $(X_0, X_1, ..., X_i=0|C_X, C_Y)$ is updated accordingly. On the other hand the opposite decision is considered, branch 32, and MAP metric P$(X_0, X_1, ..., X_i=1|C_X, C_Y)$ is evaluated.

Given the correlation model in terms of probability distribution P(X|Y), the MAP metric can be evaluated iteratively according to the following equation:

$$P(X_0,X_1,...,X_i|C_X,C_Y) = P(X_0,X_1,...,X_{i-1}|C_X,C_Y)P(X_i|C_X,Y) \quad (5)$$

with:

$$P(X_i \mid C_X, Y) = \begin{cases} 1 & \text{if no branches are performed} \\ P(X_i \mid Y) & \text{otherwise} \end{cases} \quad (6)$$

In most practical cases the adopted correlation model is memoryless, or the correlation is considered only symbol by symbol, and hence $P(X|Y) = \prod_{i=0}^{N-1} P(X_i|Y_i)$. In this case the last term of the MAP metric can be simplified as follows:

$$P(Xi|C_X, Y_i) = \begin{cases} 1 & \text{if no branches are performed} \\ P(X_i|Y_i) & \text{otherwise} \end{cases} \qquad (7)$$

The same approach can be extended to correlation models with memory. It is worth noticing that, for complexity reasons, most applications will adopt a logarithmic implementation of the previous metrics so as to substitute multiplications with additions.

In a second embodiment of the decoding method it is assumed that the side information is available at the decoder ambiguously. It is therefore assumed that $C_X$ and $C_Y$ are ambiguous representations of corresponding sources, obtained by means of the time sharing distributed arithmetic coding with interval overlapping.

At the decoder side, the time sharing coding guarantees that the coding tree, corresponding to the decoding process of X and Y do not exhibit synchronous branches. The joint decoding process of the codeword $C_X$ and $C_Y$ can be obtained through the following steps:

1) Initialize the current interval for X, $I_X$ to [0,1) and subdivide it according to the probability distribution of X.
2) Initialize the current interval for Y, $I_Y$ to [0,1) and subdivide it according to the probability distribution of Y.
3) Initialize the decoding tree for X.
4) Initialize the decoding tree for Y.
5) While the number of decoded symbols is less than N (and/or the termination condition is met):

- extend the branches of all nodes in the non ambiguous tree at time i;
- for all the nodes in the tree that can generate ambiguity at time i, set $Z_0^i = [Z_0, Z_1, ..., Z_i]$ with $Z_j = X_j$ or $Z_j = Y_j$ for $0 \leq j \leq i$, according to either the ambiguity lies in $X_i$ or $Y_i$ respectively; moreover, set $C_Z = C_X$ or $C_Z = C_Y$ based on the ambiguity;
- compare the codeword $C_Z$ with the current interval subdivisions;
- if $C_Z$ belongs to the non overlapped portion of a certain interval, decode the corresponding symbol $Z_i$ without ambiguity, and select the corresponding interval for the next iteration of this node;
- if $C_Z$ lies in the overlapped region between at least two intervals, perform a decoding branching; store $K \leq M$ alternative paths, corresponding to the alternative symbols $Z_i$ that can be decoded, update their MAP metrics $P(Z_0^i|C_X, C_Y)$ and select the corresponding interval for next iteration;
- optionally adopt pruning techniques in order to limit the number of most likely paths stored in memory; for example it can be used the Viterbi algorithm, stack and algorithm "M".

6) Output the sequence corresponding to the most likely path in the tree.

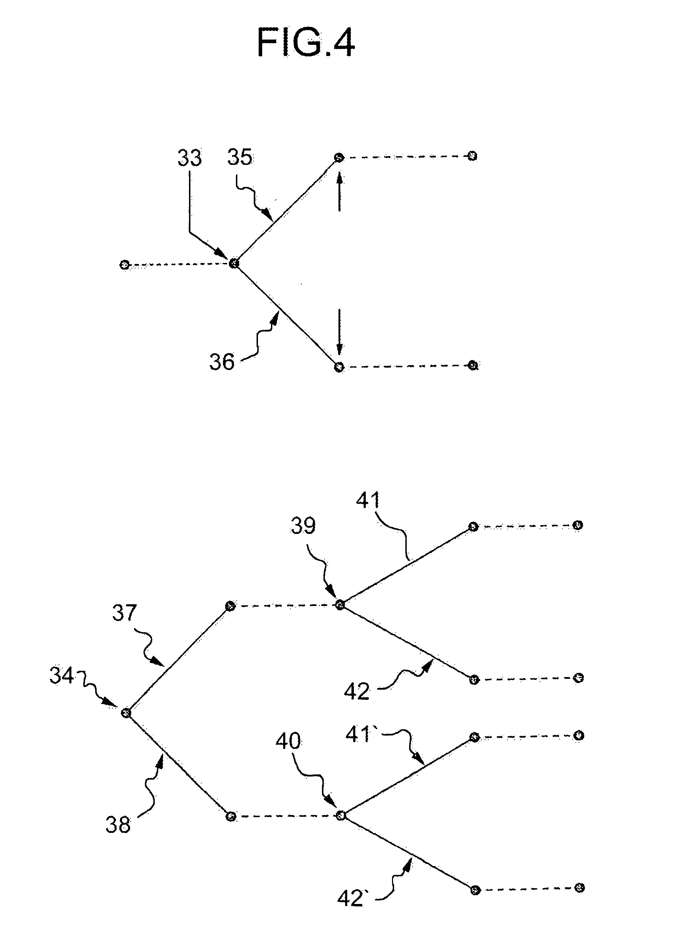

In figure 4 branches of a distributed arithmetic decoding tree in case in which both X and Y represent binary sources are illustrated. It is worth noticing that the decoding technique described can be applied also for the case in which symbols of the source X belong to an M-ary alphabet and the symbols of the source Y belong to an other M-ary alphabet with M different from the preceding. In particular, in the example reported, the decoder is not able to take a decision on the i-th symbol $Y_i$, indicated by the node 33, and on the (i+1)-th symbol $X_{i+1}$, indicated by the node 34. As a consequence, two alternative decoding attempts are pursued, respectively branches 35 and 36 for the symbol $Y_i$ and branches 37 and 38 for the symbol $X_{i+1}$. Since in this case the input source is binary, on one hand the $Y_i=0$ and $X_{i+1}=0$ hypothesis is considered, branches 35 and 37, and the MAP metric $P(X_0,X_1,...,X_{i+1}=0|C_X,C_Y)$ and $P(X_0,Y_1,...,Y_i=0|C_X, C_Y)$ are updated accordingly; on the other hand the opposite decision is considered, branches 36 and 38, and the MAP metric $P(X_0,X_1,...,X_{i+1}=1|C_X,C_Y)$ and $P(X_0,Y_1,...,Y_i=1|C_X,C_Y)$ are evaluated.

As far as X is concerned, the decoder is not further able to take a decision on the (i+2)-th symbol $X_{i+2}$, indicated by the two alternative nodes 39 and 40 deriving respectively from the branches 37 and 38. For each of the two possible nodes, 39 and 40, two alternative decoding attempts are pursued, respectively branches 41 and 42, 41' and 42', to which can be applied the same considerations above explained with reference to branches 35, 36, 37 and 38.

The coding method so uses two tree representations for X and Y in order to find the two sequences maximizing the corresponding MAP metrics P(X|C$_X$,C$_Y$) and P (Y|C$_X$,C$_Y$). The fact that, at a given time instant, there is only one tree generating ambiguous decisions permits to evaluate the necessary MAP metric.

Let us consider that, at time i, the decoding tree for X does not contain ambiguity. This means that the MAP metrics of all nodes in the tree are kept unchanged, so apply the following relation:

$$P(X_0,X_1,...,X_i|C_X,C_Y)=P(X_0,X_1,...,X_{i-1}|C_X,C_Y) \quad (8)$$

On the contrary, the tree for Y can generate branches. In such a case the MAP metric can be updated as follows:

$$P(Y_0,Y_1,...,Y_i|C_X,C_Y)=P(Y_0,Y_1,...Y_{i-1}|C_X,C_Y)P(Y_i|C_X,C_Y) \quad (9)$$

In absence of branches, P(Y$_i$|C$_X$,C$_Y$) = 1.

In the opposite case the following expression can be used:

$$P(Y_i \mid C_X, C_Y) = \sum_{m=1}^{M} P(Y_i \mid X_i = m) P(X_i = m \mid C_X, C_Y) \quad (10)$$

In the previous equality a memoryless correlation model

$$P(X|Y) = \prod_{i=0}^{N-1} P(X_i|Y_i)$$

is adopted for simplicity but the proposed approach can be extend to the case with memory.

Finally, the term P(X$_i$=m"C$_X$,C$_Y$) can be evaluated on the complementary decoding tree for X as given by the following equation:

$$P(X_i = m|C_X, C_Y) = \cdot \sum_{\text{paths with } X_i=m} P(X_0, X_1,..., X_i = m|C_X, C_Y) \quad (11)$$

If pruning techniques are adopted, not all the nodes in the tree are available and the following estimator for the term P(X$_i$=m|C$_X$,C$_Y$)can be used:

$$P(X_i = m | C_X, C_Y) = \frac{\sum_{\text{paths with Xi=m}} P(X_0, X_1,...X_i = m | C_X C_Y)}{\sum_{\text{all paths}} P(X_0, X_1,..., X_i / C_X, C_Y)} \quad (12)$$

It is worth pointing out that the present decoder can be generalized to the case of multiple correlated sources, provided that the trees of all the correlated sources are extended in parallel.

If data have been coded with bit removal (mode 2), the decoding can be achieved with an approach that is very similar to the previously described cases. From the implementation point of view, it is better to perform a sequential search along a bit "driven" decoding tree. In fact such a tree presents a branching for every bit that has been removed during the coding process.

In the following, for simplicity, only the case with unambiguous coding for the side information is presented. Of course, it is possible to extend everything here disclosed to the case in which also the side information is coded ambiguously, as above described.

The decoding method is a sequential process that can decode a given number of bit of the received codeword

$C_X$, and output the maximum number of source symbols. The number of decoded source symbols depends on the numerical precision given by the available binary digits of $C_X$.

The following steps allow to build a bit "driven" decoding tree so as to find the sequence X, maximizing the metric $P(X|C_X,C_Y=Y)$.

1) Initialize the current interval to [0,1).
2) Subdivide the interval according to the probability $\widetilde{p}_j$.
3) Initialize the decoding tree.
4) While all the codeword digits are not consumed:

- for all the nodes in the tree:

  - decode all the codeword bits preceding the next removed bit, output the corresponding source symbol and use them to update the metric $P(X|C_X,Y)$;
  - perform a branching corresponding to the removed codeword bit; decode a 0 codeword bit, decode the corresponding source symbol and updated metric; do the same for the 1 codeword bit;

- optionally adopt pruning techniques in order to limit the number of most likely paths stored in memory; for example it is possible to use the Viterbi algorithms, stack and "M" algorithm; it is possible to use also other constraints to prune non suitable paths, such as the maximum number of decoded symbols or known termination conditions.

5) Output the sequence corresponding to the most likely path in the tree.

The metric can be evaluated iteratively as in the previous implementation. Each path in the tree corresponds to a variable number of source symbols, obtained decoding a truncated representation of the codeword $C_x$. Each node metric can be obtained using the conditional probability model, relating to the sequentially decoded symbol and the side information. In other words, the node metric must be updated according to the new source symbols that must be decoded, given the increased codeword precision, when one or more bit are decoded.

## Claims

1. Distributed arithmetic coding method of a first data source (X) having an associated entropy (H), and at least a second data source (Y) statistically correlated to the first (X), in which each of said sources (X,Y) is associated with a respective sequence of symbols ( $X_0$, $X_1$, ..., $X_{N-1}$; $Y_0$, $Y_1$, $Y_{N-1}$), in which each symbol belongs to an M-ary alphabet, wherein M can be different for the two sources (X,Y), with associated a group of probabilities ($p_1$, ..., $p_M$) whose values are included in the interval from 0 to 1;
the method being **characterized by** coding a number of symbols of said first source (X) ambiguously with a predetermined number of elements per symbol ($X_0$, $X_1$, ..., $X_{N-1}$), in particular bits per symbol ($X_0$, $X_1$, ..., $X_{N-1}$), less than its entropy (H(x)), and by coding a corresponding number of symbols of said at least second data source (Y) unambiguously with a predetermined number of elements per symbol ($Y_0$, $Y_1$, ..., $Y_{N-1}$), in particular bits per symbol ($Y_0$, $Y_1$, ..., $Y_{N-1}$), greater or equal than its entropy (H(y)).

2. Arithmetic coding method according to claim 1, in which said first source (X) is coded ambiguously performing the following steps:

   a) subdivide a starting interval of real number (16) assumed equal to interval from 0 to 1, in M sub-intervals (17, 18) in which M assumes the value associated with the first source (X), said sub-intervals having predetermined lengths bigger or equal than the lengths corresponding to values of the probabilities ($p_1$,..., $p_M$) of the M-ary alphabet associated with the first source (X), so that at least two of said sub-intervals (17, 18) are partially overlapped;
   b) select a first sub-interval (17) of said starting interval (16) corresponding to the first symbol ($X_0$) of said sequence;
   c) repeat step a) using as new starting interval said first sub-interval (17);
   d) select a second sub-interval (19) of said new starting interval (17) corresponding to the second symbol ($X_1$) of said sequence ($X_0$, $X_1$, ..., $X_{N-1}$);
   e) repeat steps c) and d) updating the starting interval according to the next symbols of the sequence ($X_0$, $X_1$....,

$X_{N-1}$) until all the symbols are depleted;

f) select any number within the last sub-interval (22) corresponding to the last symbol of the sequence ($X_0$, $X_1$, ..., $X_{N-1}$) as representative of the entire sequence ($X_0$, $X_1$, ..., $X_{N-1}$) so coded and transform it in a predetermined representation, indicated codeword, constituted by a plurality of said elements, in particular a plurality of bits.

3. Coding method according to claim 1, in which the sequence ($X_0$, $X_1$, ..., $X_{N-1}$) associated with said first source (X) in encoded ambiguously performing to the following steps:

i) subdivide a starting interval of real numbers (16), assumed equal to interval from 0 to 1 in M sub-intervals in which M assumes the value associated with the first source (X), said sub-intervals having predetermined lengths equal to the lengths corresponding to the values of probabilities ($p_1$, ..., $p_M$) of the M-ary alphabet associated to the first source (X), so that said sub-intervals are not overlapped;

ii) remove a predetermined number of elements of the codeword corresponding to the sequence ($X_0$, $X_1$, ..., $X_{N-1}$).

4. Coding method according to claim 2, in which the sequence ($X_0$, $X_1$, ..., $X_{N-1}$) associated with said first source (X) is coded ambiguously, further performing the step of:

- remove a predetermined number of elements of the codeword corresponding to the sequence ($X_0$, $X_1$, ..., $X_{N-1}$).

5. Coding method according to claim 1, in which a number of symbols of said first source (X) are coded ambiguously performing the following steps:

a) subdivide a starting interval of real number (16) assumed equal to interval from 0 to 1, in M sub-intervals (17, 18) in which M assumes the value associated with the first source (X), said sub-intervals having predetermined lengths bigger or equal than the lengths corresponding to values of the probabilities ($p_1$, ..., $p_M$) of the M-ary alphabet associated with the first source (X), so that at least two of said sub-intervals (17, 18) are partially overlapped;

b) select a first sub-interval (17) of said starting interval (16) corresponding to a first symbol ($X_0$) of said sequence ($X_0$, $X_1$, ..., $X_{N-1}$);

c) repeat step a) using as new starting interval said first sub-interval (17);

d) select a second sub-interval (19) of said new starting interval (17) corresponding to a second symbol ($X_1$) of said sequence ($X_0$, $X_1$, ..., $X_{N-1}$);

e) repeat steps c) and d) updating the starting interval according to a subset of the next symbols of the sequence ($X_0$, $X_1$, ..., $X_{N-1}$) until all the symbols of said subset are depleted;

f) select any number within the last sub-interval (22) corresponding to the last symbol of the sequence ($X_0$, $X_1$, ..., $X_{N-1}$) as representative of the entire sequence ($X_0$, $X_1$, ..., $X_{N-1}$) so coded and transform it in a predetermined representation, indicated codeword, constituted by a plurality of said elements, in particular a plurality of bit; and

in which the corresponding number of symbols of the second data source (Y) are encoded unambiguously performing the following steps:

a') subdivide a starting interval of real numbers (16) assumed equal to interval from 0 to 1 in M sub-intervals, in which M assumed the value associated with the second source (Y), said sub-intervals having predetermined lengths equal to the lengths corresponding to the values of the probabilities ($p_1$, $p_M$) of the M-ary alphabet associated with the second source (Y), so that said sub-intervals are not overlapped;

b') select a first sub-interval (17) of said starting interval (16) corresponding to a first symbol ($Y_0$) of said second source (Y), such first symbol ($Y_0$) of said second source (Y) corresponding to the first symbol ($X_0$) of the first source (X);

c') repeat step a') using as new starting interval said first sub-interval (17);

d') select a second sub-interval (19) of said new starting interval (17) corresponding to a second symbol ($Y_1$) of said second source (Y), such second symbol ($Y_1$) of said second source (Y) corresponding to the second symbol ($X_1$) of the first source (X);

e') repeat steps c') and d') updating the starting interval according to a subset of the next symbols of the sequence ($Y_0$, $Y_1$, ..., $Y_{N-1}$) until all the symbols of said subset are depleted, said symbols of the subset corresponding to the symbols of the subset of the first source (X);

f) select any number within the last sub-interval (22) corresponding to the last symbol of the sequence ($Y_0$,

$Y_1, ..., Y_{N-1}$) as representative of the entire sequence ($Y_0, Y_1, ..., Y_{N-1}$) so coded and transform it in a predetermined representation, indicated codeword, constituted by a plurality of said elements, in particular a plurality of bits.

6. Coding method according to claim 3, in which the second data source (Y) is encoded ambiguously and in which the step ii) is performed on a predetermined group of elements of the codeword corresponding to the first source (X), and the ii) step is performed on an other predetermined group of elements of the codeword corresponding to at least the second data source (Y).

7. Distributed arithmetic decoding method comprising the steps of:

a) acquire at least a first codeword ($C_X$) and a second codeword ($C_Y$) associated respectively with a first data source (X) and with at least a second data source (Y) statistically correlated to the first (X), in which each of said codewords ($C_X, C_Y$) describes a respective sequence of source symbols ($X_0, X_1, ..., X_{N-1}; Y_0, Y_1, ...., Y_{N-1}$), in which each symbol belongs to an M-ary alphabet, wherein M can be different for the two sources (X, Y), with an associated group of probabilities ($p_1, ..., p_M$); said at least two codewords ($C_x, C_y$) being linked to said symbols sequence ($X_0, X_1, ..., X_{N-1}; Y_0, Y_1, ..., Y_{N-1}$) by a predetermined correlation relation; the symbols ($X_0, X_1, ..., X_{N-1}$) of the first codeword ($C_X$) being coded ambiguously and the corresponding symbols ($Y_0, Y_1, ..., Y_{N-1}$) of the second codeword ($C_Y$) are coded unambiguously;
b) subdivide at least a starting interval of real numbers associated with one of the first and second sources (X or Y), the starting interval representing the interval from 0 to 1, in M sub-intervals, in which M corresponds to the alphabet associated with said source (X or Y), said sub-intervals having predetermined lengths bigger or equal to the lengths corresponding to the values of the probabilities ($p_1, ..., p_M$) of the M-ary alphabet associated with said source (X or Y), so that at least two of said sub-intervals partially overlap;
c) initialize at least a decoding tree made up of a group of nodes each corresponding to a symbol of at least one of the at least two codewords ($C_x, C_Y$);
d) compare at least one of the at least two codewords ($C_X, C_Y$) with the sub-intervals;
e1) if said at least codewords ($C_X, C_Y$) belongs to the non-overlapped portion of a sub-interval, decode the corresponding symbol and select the corresponding sub-interval as a new starting interval;
e2) if said at least codewords ($C_X, C_Y$) belongs to the overlapped portion of at least two sub-intervals, memorize K≤M alternative paths corresponding to the K symbols that can be decoded, update their correlation relation and select the corresponding sub-interval as new starting interval;
f) repeat the operations d) and e1) or e2) for all the nodes of the tree;
g) output the sequence corresponding to most likely path in the at least one decoding tree.

**Patentansprüche**

1. Verteiltes arithmetisches Codierverfahren für eine erste Datenquelle (X), der eine Entropie (H) zugeordnet ist, sowie zumindest eine zweite Datenquelle (Y), die mit der ersten (X) statistisch korreliert ist, wobei jeder der Quellen (X, Y) eine entsprechende Folge von Symbolen ($X_0, X_1, ... X_{N-1}; Y_0, Y_1, Y_{N-1}$) zugeordnet ist, wobei jedes Symbol zu einem M-stelligen Alphabet gehört, wobei M für die beiden Quellen (X, Y) verschieden sein kann, wobei eine Gruppe von Wahrscheinlichkeiten ($p_1, ..., p_M$) zugeordnet ist, deren Werte im Intervall von 0 bis 1 enthalten sind; wobei das Verfahren **dadurch gekennzeichnet ist, dass** eine Zahl von Symbolen der ersten Quelle (X) mehrdeutig mit einer vorgegebenen Zahl von Elementen pro Symbol ($X_0, X_1, ..., X_{N-1}$) im Besonderen mit Bits pro Symbol ($X_0, X_1, ..., X_{N-1}$) codiert wird, die kleiner als ihre Entropie (H(x)) ist, und eine entsprechende Zahl von Symbolen der zumindest zweiten Datenquelle (Y) eindeutig mit einer vorgegebenen Zahl von Elementen pro Symbol ($Y_0, Y_1, ..., Y_{N-1}$) im Besonderen mit Bits pro Symbol ($Y_0, Y_1, ..., Y_{N-1}$) codiert wird, die größer oder gleich ihrer Entropie (H(y)) ist.

2. Arithmetisches Codierverfahren gemäß Anspruch 1, wobei die erste Quelle (X) mehrdeutig codiert wird, wobei folgende Schritte ausgeführt werden:

a) Unterteilen eines Startintervalls einer reellen Zahl (16), von der vorausgesetzt wird, dass sie im Intervall von 0 bis 1 liegt, in M Subintervalle (17, 18), wobei vorausgesetzt wird, dass M den Wert annimmt, der der ersten Quelle (X) zugeordnet ist, wobei die Subintervalle vorgegebene Längen besitzen, die größer oder gleich den Längen sind, die den Werten der Wahrscheinlichkeiten ($p_1, ..., p_M$) des M-stelligen Alphabets entsprechen, das der ersten Quelle (X) zugeordnet ist, so dass sich zumindest zwei der Subintervalle (17, 18) teilweise überlappen;
b) Auswählen eines ersten Subintervalls (17) des Startintervalls (16), das dem ersten Symbol ($X_0$) der Folge

entspricht;

c) Wiederholen des Schritts a), wobei als neues Startintervall das erste Subintervall (17) verwendet wird;

d) Auswählen eines zweiten Subintervalls (19) des neuen Startintervalls (17), das dem zweiten Symbol ($X_1$) der Folge ($X_0$, $X_1$, ..., $X_{N-1}$) entspricht;

e) Wiederholen der Schritte c) und d) zum Updaten des Startintervalls gemäß den nächsten Symbolen der Folge ($X_0$, $X_1$, ..., $X_{N-1}$), bis alle Symbole aufgebraucht sind;

f) Auswählen irgendeiner Zahl innerhalb des letzten Subintervalls (22), die dem letzten Symbol der Folge ($X_0$, $X_1$, ..., $X_{N-1}$) entspricht, als Repräsentant der gesamten auf diese Weise codierten Folge ($X_0$, $X_1$, ..., $X_{N-1}$) und Umsetzen in eine vorgegebene Darstellung, die als Codewort bezeichnet und von einer Vielzahl der Elemente gebildet wird, im Besonderen von einer Vielzahl von Bits.

3. Codierverfahren gemäß Anspruch 1, wobei die Folge ($X_0$, $X_1$, ..., $X_{N-1}$), die der ersten Quelle (X) zugeordnet ist, mehrdeutig codiert wird, wobei folgende Schritte ausgeführt werden:

i) Unterteilen eines Startintervalls von reellen Zahlen (16), von denen vorausgesetzt wird, dass sie im Intervall von 0 bis 1 liegen, in M Subintervalle, wobei vorausgesetzt wird, dass M den Wert annimmt, der der ersten Quelle (X) zugeordnet ist, wobei die Subintervalle vorgegebene Längen besitzen, die gleich den Längen sind, die den Werten der Wahrscheinlichkeiten ($p_1$, ..., $p_M$) des M-stelligen Alphabets entsprechen, das der ersten Quelle (X) zugeordnet ist, so dass sich die Subintervalle nicht überlappen;

ii) Entfernen einer vorgegebenen Zahl von Elementen des Codeworts, das der Folge ($X_0$, $X_1$, ..., $X_{N-1}$) entspricht.

4. Codierverfahren gemäß Anspruch 2, wobei die Folge ($X_0$, $X_1$, ..., $X_{N-1}$), die der ersten Quelle (X) zugeordnet ist, mehrdeutig codiert wird, wobei weiters folgender Schritt ausgeführt wird:

- Entfernen einer vorgegebenen Zahl von Elementen des Codeworts, das der Folge ($X_0$, $X_1$, ..., $X_{N-1}$) entspricht.

5. Codierverfahren gemäß Anspruch 1, wobei eine Zahl von Symbolen der ersten Quelle (X) dadurch mehrdeutig codiert wird, dass folgende Schritte ausgeführt werden:

a) Unterteilen eines Startintervalls einer reellen Zahl (16), von der vorausgesetzt wird, dass sie im Intervall von 0 bis 1 liegt, in M Subintervalle (17, 18), wobei vorausgesetzt wird, dass M den Wert annimmt, der der ersten Quelle (X) zugeordnet ist, wobei die Subintervalle vorgegebene Längen besitzen, die größer oder gleich den Längen sind, die den Werten der Wahrscheinlichkeiten ($p_1$, ..., $p_M$) des M-stelligen Alphabets entsprechen, das der ersten Quelle (X) zugeordnet ist, so dass sich zumindest zwei Subintervalle (17, 18) teilweise überlappen;

b) Auswählen eines ersten Subintervalls (17) des Startintervalls (16), das einem ersten Symbol ($X_0$) der Folge ($X_0$, $X_1$, ..., $X_{N-1}$) entspricht;

c) Wiederholen des Schritts a), wobei als neues Startintervall das erste Subintervall (17) verwendet wird;

d) Auswählen eines zweiten Subintervalls (19) des neuen Startintervalls (17), das einem zweiten Symbol ($X_1$) der Folge ($X_0$, $X_1$, ..., $X_{N-1}$) entspricht;

e) Wiederholen der Schritte c) und d) zum Updaten des Startintervalls gemäß einer Teilmenge der nächsten Symbole der Folge ($X_0$, $X_1$, ..., $X_{N-1}$) bis alle Symbole der Teilmenge aufgebraucht sind;

f) Auswählen irgendeiner Zahl im letzten Subintervall (22), die dem letzten Symbol der Folge ($X_0$, $X_1$, ..., $X_{N-1}$) entspricht, als Repräsentant der gesamten auf diese Weise codierten Folge ($X_0$, $X_1$, ..., $X_{N-1}$) und Umsetzen in eine vorgegebene Darstellung, die als Codewort bezeichnet und von einer Vielzahl der Elemente gebildet wird, im Besonderen von einer Vielzahl von Bits; und

wobei die entsprechende Zahl von Symbolen der zweiten Datenquelle (Y) eindeutig codiert wird, wobei folgende Schritte ausgeführt werden:

a') Unterteilen eines Startintervalls von reellen Zahlen (16), von denen vorausgesetzt wird, dass sie im Intervall von 0 bis 1 liegen, in M Subintervalle, wobei vorausgesetzt wird, dass M den Wert annimmt, der der zweiten Quelle (Y) zugeordnet ist, wobei die Subintervalle vorgegebene Längen besitzen, die gleich den Längen sind, die den Werten der Wahrscheinlichkeiten ($p_1$, $p_M$) des M-stelligen Alphabets entsprechen, das der zweiten Quelle (Y) zugeordnet ist, so dass sich die Subintervalle nicht überlappen;

b') Auswählen eines ersten Subintervalls (17) des Startintervalls (16), das einem ersten Symbol ($Y_0$) der zweiten Quelle (Y) entspricht, wobei das erste Symbol ($Y_0$) der zweiten Quelle (Y) dem ersten Symbol ($X_0$) der ersten Quelle (X) entspricht;

c') Wiederholen des Schritts a'), wobei als neues Startintervall das erste Subintervall (17) verwendet wird;

d') Auswählen eines zweiten Subintervalls (19) des neuen Startintervalls (17), das einem zweiten Symbol ($Y_1$) der zweiten Quelle (Y) entspricht, wobei das zweite Symbol ($Y_1$) der zweiten Quelle (Y) dem zweiten Symbol ($X_1$) der ersten Quelle (X) entspricht;

e') Wiederholen der Schritte c') und d') zum Updaten des Startintervalls gemäß einer Teilmenge der nächsten Symbole der Folge ($Y_0$, $Y_1$, ..., $Y_{N-1}$), bis alle Symbole der Teilmenge aufgebraucht sind, wobei Symbole der Teilmenge den Symbolen der Teilmenge der ersten Quelle (X) entsprechen;

f') Auswählen irgendeiner Zahl im letzten Subintervall (22), die dem letzten Symbol der Folge ($Y_0$, $Y_1$, ..., $Y_{N-1}$) entspricht, als Repräsentant der gesamten auf diese Weise codierten Folge ($Y_0$, $Y_1$, ..., $Y_{N-1}$) und Umsetzen in eine vorgegebene Darstellung, die als Codewort bezeichnet und von einer Vielzahl der Elemente gebildet wird, im Besonderen von einer Vielzahl von Bits.

6. Codierverfahren gemäß Anspruch 3, wobei die zweite Datenquelle (Y) mehrdeutig codiert wird, und wobei der Schritt ii) bei einer vorgegebenen Gruppe von Elementen des Codeworts, das der ersten Quelle (X) entspricht, ausgeführt wird, und wobei der ii)-Schritt bei einer anderen Gruppe von Elementen des Codeworts, das der zumindest zweiten Datenquelle (Y) entspricht, ausgeführt wird.

7. Verteiltes arithmetisches Codierverfahren, wobei das Verfahren folgende Schritte umfasst;

a) Erlangen zumindest eines ersten Codeworts ($C_x$) sowie eines zweiten Codeworts ($C_y$), die jeweils einer ersten Datenquelle (X) und zumindest einer zweiten Datenquelle (Y) zugeordnet sind, die statistisch mit der ersten (X) korreliert ist, wobei jedes dieser Codewörter ($C_x$, $C_y$) eine entsprechende Folge von Quellensymbolen ($X_0$, $X_1$, ..., $X_{N-1}$; $Y_0$, $Y_1$, ..., $Y_{N-1}$) beschreibt, wobei jedes Symbol einem M-stelligen Alphabet angehört, wobei M für die beiden Quellen (X, Y) verschieden sein kann, wobei eine Gruppe von Wahrscheinlichkeiten ($p_1$, ..., $p_M$) zugeordnet ist; wobei die zumindest zwei Codewörter ($C_x$, $C_y$) mit der Symbolfolge ($X_0$, $X_1$, ..., $X_{N-1}$; $Y_0$, $Y_1$, ..., $Y_{N-1}$) durch eine vorgegebene Korrelationsbeziehung verkettet sind; wobei die Symbole ($X_0$, $X_1$, ..., $X_{N-1}$) des ersten Codeworts ($C_x$) mehrdeutig codiert werden und die entsprechenden Symbole ($Y_0$, $Y_1$, ..., $Y_{N-1}$) des zweiten Codeworts ($C_y$) eindeutig codiert werden;

b) Unterteilen zumindest eines Startintervalls von reellen Zahlen, die der ersten Quelle (X) oder der zweiten Quelle (Y) zugeordnet sind, wobei das Startintervall das Intervall von 0 bis 1 kennzeichnet, in M Subintervalle, wobei M dem Alphabet entspricht, das der Quelle (X oder Y) zugeordnet ist, wobei die Subintervalle vorgegebene Längen besitzen, die größer oder gleich den Längen sind, die den Werten der Wahrscheinlichkeiten ($p_1$, ..., $p_M$) des M-stelligen Alphabets entsprechen, das der Quelle (X oder Y) zugeordnet ist, so dass sich zumindest zwei Subintervalle teilweise überlappen;

c) Initialisieren zumindest eines Decodierbaums, der aus einer Gruppe von Knoten besteht, von denen jeder einem Symbol von zumindest einem der zumindest zwei Codewörter ($C_x$, $C_y$) entspricht;

d) Vergleichen von zumindest einem der zumindest zwei Codewörter ($C_x$, $C_y$) mit den Subintervallen;

e1) Decodieren des entsprechenden Symbols und Auswählen des entsprechenden Subintervalls als neues Startintervall, wenn das zumindest einem der beiden Codeworte ($C_x$, $C_y$) dem nicht überlappten Teil eines Subintervalls entspricht;

e2) Speichern von $K \leq M$ alternativen Wegen, die den K Symbolen entsprechen, die decodiert werden können, Updaten ihrer Korrelationsbeziehung und Auswählen des entsprechenden Subintervalls als neues Startintervall, wenn zumindest eines der Codewörter ($C_x$, $C_y$) dem überlappten Teil von zumindest zwei Subintervallen entspricht;

f) Wiederholen der Vorgänge d) und e1) oder e2) für alle Knoten des Baums;

g) Ausgeben der Folge, die dem wahrscheinlichsten Weg in dem zumindest einen Decodierbaum entspricht.

## Revendications

1. Procédé de codage arithmétique distribué d'une première source de données (X) ayant une entropie associée (H), et au moins une seconde source de données (Y) corrélée statistiquement à la première (X), où chacune desdites sources (X, Y) est associée à une séquence respective de symboles ($X_0$, $X_1$, ..., $X_{N-1}$; $Y_0$, $Y_1$, ..., $Y_{N-1}$), où chaque symbole appartient à un alphabet M-aire, **caractérisé en ce que** M peut être différent pour les deux sources (X, Y), avec un groupe de probabilités associé ($p_1$, ..., $p_M$) dont les valeurs sont incluses dans l'intervalle de 0 à 1 ;

le procédé étant **caractérisé par** le codage d'un nombre de symboles de ladite première source (X) de façon ambiguë avec un nombre prédéterminé d'éléments par symbole ($X_0$, $X_1$, ..., $X_{N-1}$), en particulier des bits par symbole ($X_0$, $N_1$, ..., $X_{N-1}$), inférieur à son entropie (H(x)), et par le codage d'un nombre de symboles correspondant de ladite au moins une seconde source de données (Y) de façon non ambiguë avec un nombre prédéterminé d'éléments

par symbole ($Y_0$, $Y_1$ ..., $Y_{N-1}$), en particulier des bits par symbole ($Y_0$, $Y_1$, ..., $Y_{N-1}$), supérieur ou égal à son entropie ($H(y)$).

2. Procédé de codage arithmétique selon la revendication 1, dans lequel ladite première source (X) est codée de façon ambiguë en effectuant les étapes suivantes :

a) subdiviser un intervalle de départ de nombre réel (16) supposé égal à l'intervalle de 0 à 1, en M sous-intervalles (17, 18), où M prend la valeur associée à la première source (X), lesdits sous-intervalles ayant des longueurs prédéterminées supérieures ou égales aux longueurs correspondant aux valeurs des probabilités ($p_1$, ..., $p_M$) de l'alphabet M-aire associé à la première source (X), de sorte qu'au moins deux desdits sous-intervalles (17, 18) soient partiellement chevauchés ;
b) sélectionner un premier sous-intervalle (17) dudit intervalle de départ (16) correspondant au premier symbole ($X_0$) de ladite séquence ;
c) répéter l'étape a) en utilisant comme nouvel intervalle de départ ledit premier sous-intervalle (17) ;
d) sélectionner un second sous-intervalle (19) dudit nouvel intervalle de départ (17) correspondant au second symbole ($X_1$) de ladite séquence ($X_0$, $X_1$, ..., $X_{N-1}$) ;
e) répéter les étapes c) et d) en mettant à jour l'intervalle de départ selon les symboles suivants de la séquence ($X_0$, $X_1$, ..., $X_{N-1}$) jusqu'à ce que tous les symboles soient épuisés ;
f) sélectionner un nombre quelconque à l'intérieur du dernier sous-intervalle (22) correspondant au dernier symbole de la séquence ($X_0$, $X_1$, ..., $X_{N-1}$) comme représentatif de la séquence entière ($X_0$, $X_1$, ..., $X_{N-1}$) ainsi codée et le transformer dans une représentation prédéterminée, mot de code indiqué, constitué d'une pluralité desdits éléments, en particulier une pluralité de bits.

3. Procédé de codage selon la revendication 1, dans lequel la séquence ($X_0$, $X_1$, ..., $X_{N-1}$) associée à ladite première source (X) est encodée de façon ambiguë en effectuant les étapes suivantes :

i) subdiviser un intervalle de départ de nombres réels (16), supposé égal à l'intervalle de 0 à 1 en M sous-intervalles, où M prend la valeur associée à la première source (X), lesdits sous-intervalles ayant des longueurs prédéterminées égales aux longueurs correspondant aux valeurs de probabilités ($p_1$, ..., $p_M$) de l'alphabet M-aire associé à la première source (X), de sorte que lesdits sous-intervalles ne soient pas chevauchés ;
ii) supprimer un nombre prédéterminé d'éléments du mot de code correspondant à la séquence ($X_0$, $X_1$, ..., $X_{N-1}$).

4. Procédé de codage selon la revendication 2, dans lequel la séquence ($X_0$, $X_1$, ..., $X_{N-1}$) associée à ladite première source (X) est codée de façon ambiguë en effectuant en outre l'étape consistant à :

- supprimer un nombre prédéterminé d'éléments du mot de code correspondant à la séquence ($X_0$, $X_1$, ..., $X_{N-1}$).

5. Procédé de codage selon la revendication 1, dans lequel un nombre de symboles de ladite première source (X) est codé de façon ambiguë en effectuant les étapes suivantes :

a) subdiviser un intervalle de départ de nombre réel (16) supposé égal à l'intervalle de 0 à 1, en M sous-intervalles (17, 18), où M prend la valeur associée à la première source (X), lesdits sous-intervalles ayant des longueurs prédéterminées supérieures ou égales aux longueurs correspondant à des valeurs des probabilités ($p_1$, ..., $p_M$) de l'alphabet M-aire associé à la première source (X), de sorte qu'au moins deux desdits sous-intervalles (17, 18) soient partiellement chevauchés ;
b) sélectionner un premier sous-intervalle (17) dudit intervalle de départ (16) correspondant à un premier symbole ($X_0$) de ladite séquence ($X_0$, $X_1$, ..., $X_{N-1}$);
c) répéter l'étape a) en utilisant comme nouvel intervalle de départ ledit premier sous-intervalle (17) ;
d) sélectionner un second sous-intervalle (19) dudit nouvel intervalle de départ (17) correspondant à un second symbole ($X_1$) de ladite séquence ($X_0$, $X_1$, ..., $X_{N-1}$) ;
e) répéter les étapes c) et d) en mettant à jour l'intervalle de départ selon un sous-ensemble des symboles suivants de la séquence ($X_0$, $X_1$, ..., $X_{N-1}$) jusqu'à ce que tous les symboles dudit sous-ensemble soient épuisés ;
f) sélectionner un nombre quelconque à l'intérieur du dernier sous-intervalle (22) correspondant au dernier symbole de la séquence ($X_0$, $X_1$, ..., $X_{N-1}$) comme représentatif de la séquence entière ($X_0$, $X_1$, ..., $X_{N-1}$) ainsi codée et le transformer dans une représentation prédéterminée, mot de code indiqué, constitué d'une pluralité desdits éléments, en particulier une pluralité de bits ; et

où le nombre de symboles correspondant de la seconde source de données (Y) est encodé de façon non ambiguë en effectuant les étapes suivantes :

a') subdiviser un intervalle de départ de nombres réels (16) supposé égal à l'intervalle de 0 à 1 en M sous-intervalles, où M prend la valeur associée à la seconde source (Y), lesdits sous-intervalles ayant des longueurs prédéterminées égales aux longueurs correspondant aux valeurs des probabilités ($p_1$, ..., $p_M$) de l'alphabet M-aire associé à la seconde source (Y), de sorte que lesdits sous-intervalles ne soient pas chevauchés ;

b') sélectionner un premier sous-intervalle (17) dudit intervalle de départ (16) correspondant à un premier symbole ($Y_0$) de ladite seconde source (Y), un tel premier symbole ($Y_0$) de ladite seconde source (Y) correspondant au premier symbole ($X_0$) de la première source (X) ;

c') répéter l'étape a') en utilisant comme nouvel intervalle de départ ledit premier sous-intervalle (17) ;

d') sélectionner un second sous-intervalle (19) dudit nouvel intervalle de départ (17) correspondant à un second symbole ($Y_1$) de ladite seconde source (Y), un tel second symbole ($Y_1$) de ladite seconde source (Y) correspondant au second symbole ($X_1$) de la première source (X) ;

e') répéter les étapes c') et d') en mettant à jour l'intervalle de départ selon un sous-ensemble des symboles suivants de la séquence ($Y_0$, $Y_1$, ..., $Y_{N-1}$) jusqu'à ce que tous les symboles dudit sous-ensemble soient épuisés, lesdits symboles du sous-ensemble correspondant aux symboles du sous-ensemble de la première source (X) ;

f) sélectionner un nombre quelconque à l'intérieur du dernier sous-intervalle (22) correspondant au dernier symbole de la séquence ($Y_0$, $Y_1$, ..., $Y_{N-1}$) comme représentatif de la séquence entière ($Y_0$, $Y_1$, ..., $Y_{N-1}$) ainsi codée et le transformer dans une représentation prédéterminée, mot de code indiqué, constitué d'une pluralité desdits éléments, en particulier une pluralité de bits.

6. Procédé de codage selon la revendication 3, dans lequel la seconde source de données (Y) est encodée de façon ambiguë et dans lequel l'étape ii) est effectuée sur un groupe prédéterminé d'éléments du mot de code correspondant à la première source (X), et l'étape ii) est effectuée sur un autre groupe prédéterminé d'éléments du mot de code correspondant au moins à la seconde source de données (Y).

7. Procédé de décodage arithmétique distribué comprenant les étapes consistant à :

a) acquérir au moins un premier mot de code ($C_X$) et un second mode de code ($C_Y$) associés respectivement à une première source de données (X) et à au moins une seconde source de données (Y) corrélée statistiquement à la première (X), où chacun desdits mots de code ($C_X$, $C_Y$) décrit une séquence respective de symboles sources ($X_0$, $X_1$, ..., $X_{N-1}$ ; $Y_0$, $Y_1$, ..., $Y_{N-1}$), où chaque symbole appartient à un alphabet M-aire **caractérisé en ce que** M peut être différent pour les deux sources (X, Y) avec un groupe associé de probabilités ($p_1$, ..., $p_M$) ; lesdits au moins deux mots de code ($C_X$, $C_Y$) étant reliés à ladite séquence de symboles ($X_0$, $X_1$, ..., $X_{N-1}$ ; $Y_0$, $Y_1$ ..., $Y_{N-1}$) par une relation de corrélation prédéterminée ; les symboles ($X_0$, $X_1$, ..., $X_{N-1}$) du premier mot de code ($C_X$) étant codés de façon ambiguë et les symboles correspondants ($Y_0$, $Y_1$, ..., $Y_{N-1}$), du second mot de code ($C_Y$) sont codés de façon non ambiguë ;

b) subdiviser au moins un intervalle de départ de nombres réels associé à une de la première et de la seconde source (X ou Y), l'intervalle de départ représentant l'intervalle de 0 à 1, en M sous-intervalles, où M correspond à l'alphabet associé à ladite source (X ou Y), lesdits sous-intervalles ayant des longueurs prédéterminées supérieures ou égales aux longueurs correspondant aux valeurs des probabilités ($p_1$, ..., $p_M$) de l'alphabet M-aire associé à ladite source (X ou Y), de sorte qu'au moins deux desdits sous-intervalles se chevauchent partiellement ;

c) initialiser au moins un arbre de décodage composé d'un groupe de noeuds correspondant chacun à un symbole d'au moins un des au moins deux mots de code ($C_X$, $C_Y$) ;

d) comparer au moins un des au moins deux mots de code ($C_X$, $C_Y$) avec les sous-intervalles ;

e1) si ledit au moins un des au moins deux mots de code ($C_X$, $C_Y$) appartient à la partie non chevauchée d'un sous-intervalle, décoder le symbole correspondant et sélectionner le sous-intervalle correspondant comme un nouvel intervalle de départ ;

e2) si ledit au moins un des au moins deux mots de code ($C_X$, $C_Y$) appartient à la partie chevauchée d'au moins deux sous-intervalles, mémoriser K≤M chemins alternatifs correspondant aux K symboles qui peuvent être décodés, mettre à jour leur relation de corrélation et sélectionner le sous-intervalle correspondant comme nouvel intervalle de départ ;

f) répéter les opérations d) et e1) ou e2) pour tous les nceuds de l'arbre ;

g) sortir la séquence correspondant au chemin le plus probable dans le au moins un arbre de décodage.

# FIG.1

# FIG.2

# FIG.3

# FIG.4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2002176494 A